# EUROPEAN PATENT APPLICATION

(11) **EP 4 471 849 A1**
(43) Date of publication of application: **04.12.2024**
(21) Application number: 22924141.9
(22) Date of filing: 15.12.2022
(51) Int. Cl.: H01L 23/473, H05K 7/20

(54) **TEMPERATURE CONTROL DEVICE AND METHOD FOR MANUFACTURING TEMPERATURE CONTROL DEVICE**

(30) Priority: 26.01.2022 JP 2022010379
(71) Applicant: Mitsui Chemicals, Inc., Tokyo 104-0028 (JP)
(72) Inventor: TOMINAGA, Takahiro, Sodegaura-shi, Chiba 299-0265 (JP); MORIMOTO, Kai, Sodegaura-shi, Chiba 299-0265 (JP)
(74) Representative: J A Kemp LLP
(86) International application number: PCT/JP2022/046240
(87) International publication number: WO 2023/145290

(57) **Abstract**

The temperature control device of the disclosure is a temperature control device for controlling the temperature of at least one heat exchange object. This temperature control device includes: a first plate made of a metal; a second plate; a flow path wall part sandwiched between the first plate and the second plate; and a resin fixing part fixing the second plate to the first plate. An internal flow path for circulating a heat exchange medium is formed by at least one of the first plate or the second plate, and the flow path wall part. The first plate includes at least one connection region for thermally connecting the at least one heat exchange object thereto, at an outer main surface of a side at which the flow path wall part is not arranged. The resin fixing part covers a region of the outer main surface, excluding the at least one connection region.

## Description

### Technical Field

The present disclosure relates to: a temperature control device; and a method of producing a temperature control device.

### Background Art

Central processing units (CPUs) installed in computers and secondary batteries mounted on electric vehicles generate heat during operation. As means for cooling these heat-generating bodies, various cooling devices using a cooling medium have been proposed.

Patent Document 1 proposes a cooling device for cooling a heat-generating body. The cooling device disclosed in Patent Document 1 includes a resin member, a first metal member, and a second metal member. A refrigerant flow path is formed in the resin member. The first metal member has a first surface and a second surface. The first surface of the first metal member contacts the resin member. The second surface of the first metal member contacts a first heat-generating body. The second metal member also has a first surface and a second surface. The first surface of the second metal member contacts the resin member. The second surface of the second metal member contacts a second heat-generating body. The second main surfaces of the first metal member and the second metal member are exposed.

Patent Document 1: Japanese Patent Application Laid-Open (JP-A) No. 2016-9776

### SUMMARY OF THE INVENTION

### Technical Problem

In recent years, in association with size reduction of electronic devices, a plurality of electronic components are often integrated to be mounted. Such the plurality of electronic components (hereinafter, also referred to as "integrated electronic component") include a heat-generating body and a non-heat-generating body in some cases. The heat-generating body generates heat by its operation. The non-heat-generating body hardly generates heat by its operation.

In the cooling device disclosed in Patent Document 1, the second main surfaces of the first metal member and the second metal member are exposed. Therefore, when a heat-generating body included in an integrated electronic component is arranged in contact with one of the first metal member or the second metal member for cooling of the heat-generating body, a non-heat-generating body included in the integrated electronic component may also contact the one of the first metal member or the second metal member. The first metal member and the second metal member are each readily electrically conductive. As a result, in the non-heat-generating body that is not to be cooled, a short circuit may occur due to a physical contact with the one of the first metal member or the second metal member. The occurrence of such a short circuit of an electronic component or the like potentially induces a failure or malfunction of an electronic device.

In view of the above-described circumstances, an object of the disclosure is to provide: a temperature control device capable of inhibiting the occurrence of a short circuit of an electronic device caused by a physical contact with the electronic device that is not a heat exchange object; and a method of producing a temperature control device.

### Solution to Problem

Means for solving the above-described problems encompass the following embodiments.
<1> A temperature control device for controlling a temperature of at least one heat exchange object, the temperature control device including:
   a first plate made of a metal;
   a second plate;
   a flow path wall part sandwiched between the first plate and the second plate; and
   a resin fixing part fixing the second plate to the first plate, wherein:
      an internal flow path for circulating a heat exchange medium is formed by at least one of the first plate or the second plate, and the flow path wall part,
      the first plate includes at least one connection region for thermally connecting the at least one heat exchange object thereto, at an outer main surface of a side at which the flow path wall part is not arranged, and
      the resin fixing part covers a region of the outer main surface excluding the at least one connection region.
<2> The temperature control device according to <1>, wherein the first plate includes at least one strut that physically contacts the second plate at a portion of an inner main surface at an opposite side from the outer main surface, the portion contacting the resin fixing part.
<3> The temperature control device according to <1> or <2>, wherein the first plate has a fine uneven structure at a portion that contacts the resin fixing part.
<4> The temperature control device according to any one of <1> to <3>, wherein:
   the second plate is made of a metal, and
   at least one of the first plate or the second plate, and the flow path wall part, are an integrally molded product made of a metal.
<5> The temperature control device according to any one of <1> to <4>, wherein:
   the second plate is made of a metal, and
   the flow path wall part is made of a resin.
<6> The temperature control device according to <4> or <5>, wherein:
   the at least one heat exchange object includes a plurality of heat exchange objects,
   the second plate includes at least one other connection region for thermally connecting at least one of the plurality of heat exchange objects thereto, at an outer main surface of a side at which the flow path wall part is not arranged, and
   the resin fixing part covers a region of the outer main surface of the second plate excluding the at least one other connection region.
<7> The temperature control device according to any one of <4> to <6>, wherein the second plate has a fine uneven structure at a portion that contacts the resin fixing part.
<8> The temperature control device according to any one of <1> to <3>, wherein the second plate and the flow path wall part are made of a resin.
<9> The temperature control device according to any one of <1> to <8>, wherein the resin fixing part is formed by insert molding.
<10> A method of producing a temperature control device, which the temperature control device according to any one of <1> to <9>, the method includes:
   a step of preparing the first plate, the second plate, and the flow path wall part;
   a step of sandwiching the flow path wall part between the first plate and the second plate and forming a gap at which the first plate and the second plate face each other; and
   a step of insert-molding the resin fixing part at a region excluding the gap and excluding the at least one connection region of the outer main surface of the first plate.
<11> The method of producing a temperature control device according to <10>, wherein the first plate includes at least one strut that physically contacts the second plate at a portion of an inner main surface at an opposite side from the outer main surface, the portion contacting the resin fixing part.

### Advantageous Effects of Invention

According to the disclosure, a temperature control device capable of inhibiting the occurrence of a short circuit of an electronic device caused by a physical contact with the electronic device that is not a heat exchange object, and a method of producing a temperature control device are provided.

### BRIEF DESCRIPTION OF DRAWINGS

FIG. 1 is a perspective view illustrating the outer appearance of the temperature control device according to a first embodiment of the disclosure;
FIG. 2 is another perspective view illustrating the outer appearance of the temperature control device according to the first embodiment of the disclosure;
FIG. 3 is a cross-sectional view taken along the C3-C3 line of FIG. 1;
FIG. 4 is a perspective view illustrating the outer appearance of a flow path wall part, a partition member, and a first plate according to the first embodiment of the disclosure;
FIG. 5 is a perspective view illustrating the outer appearance of the temperature control device according to a second embodiment of the disclosure;
FIG. 6 is a cross-sectional view taken along the C6-C6 line of FIG. 5;
FIG. 7 is a perspective view illustrating the outer appearance of the temperature control device according to a third embodiment of the disclosure;
FIG. 8 is a cross-sectional view of the temperature control device according to the third embodiment of the disclosure;
FIG. 9 is a cross-sectional view of the temperature control device according to a fourth embodiment of the disclosure;
FIG. 10 is a cross-sectional view of the temperature control device according to a fifth embodiment of the disclosure; and
FIG. 11 is a cross-sectional view of the temperature control device according to a sixth embodiment of the disclosure.

### DESCRIPTION OF EMBODIMENTS

In the present specification, those numerical ranges that are expressed with "to" each denote a range that includes the numerical values stated before and after "to" as the minimum value and the maximum value, respectively.

The term "step" used herein encompasses not only a discrete step but also a step that cannot be clearly distinguished from other steps, as long as the intended purpose of the step is achieved.

Embodiments of the temperature control device according to the disclosure will now be described referring to the drawings. In the drawings, the same or corresponding parts are denoted by the same reference symbol, and description thereof is not repeated.

### (1) Temperature Control Device

The temperature control device of the disclosure is used for controlling the temperature of at least one heat exchange object. Specifically, the temperature control device thermally contacts the heat exchange object, and thereby draws heat from the heat exchange object or provides heat to the heat exchange object.

Examples of the heat exchange object include electronic devices. Examples of the electronic devices include, but not particularly limited to: CPUs, memory modules, battery modules, and power modules. Examples of the memory modules include dual inline memory modules (DIMMs). Examples of the battery modules include lithium ion battery modules.

The temperature control device of the disclosure includes a first plate (hereinafter, also referred to as "first metal plate"), a second plate, a flow path wall part, and a resin fixing part. The flow path wall part is sandwiched between the first metal plate and the second plate. The resin fixing part fixes the second plate to the first metal plate. An internal flow path for circulating a heat exchange medium is formed by at least one of the first metal plate or the second plate, and the flow path wall part. The first metal plate has at least one connection region (hereinafter, also referred to as "first connection region") for thermally connecting the above-described at least one heat exchange object thereto, at an outer main surface of a side at which the flow path wall part is not arranged. The resin fixing part covers a region of the outer main surface excluding the above-described at least one first connection region.

In the disclosure, the "internal flow path" refers to a space for circulating a heat exchange medium.

The "resin fixing part" refers to an electrically insulating resin fixing part. For example, the resin fixing part has a volume resistivity of less than 1 × 10¹⁶ Ω·cm at 20°C.

The temperature control device of the disclosure has the above-described configuration and is, therefore, capable of inhibiting the occurrence of a short circuit of an electronic component caused by a physical contact with an electronic device that is not a heat exchange object.

This effect is presumably attributed to, but not limited to, the following reasons.

The resin fixing part covers a region of the outer main surface of the first metal plate, excluding the at least one first connection region. Therefore, a main surface of the temperature control device at the side of the first metal plate is composed of the at least one first connection region and an electrically insulating region. This electrically insulating region is formed by the resin fixing part, and has electrically insulating properties. This makes an electronic device, which is not a heat exchange object, unlikely to be electrically connected with the first metal plate even when the electronic device physically contacts the temperature control device. As a result, the temperature control device of the disclosure can inhibit the occurrence of a short circuit of an electronic component caused by a physical contact with an electronic device that is not a heat exchange object.

The first metal plate preferably has at least one strut (hereinafter, also referred to as "first strut") that physically contacts the second plate at a portion of an inner main surface at an opposite side from the outer main surface, the portion contacting the resin fixing part.

The first strut functions as a support of the second plate. Accordingly, even when a pressing force is applied to the second plate in the thickness direction of the second plate, the second plate is unlikely to be deformed. For example, when the resin fixing part is formed by insert molding, the first strut serves as a support of the second plate against an injection pressure; therefore, the second plate is unlikely to be deformed. As a result, in the temperature control device, a loss of the pressure of a heat exchange medium circulating in the internal flow path can be reduced. In other words, in the temperature control device, a heat exchange medium can be efficiently circulated in the internal flow path.

The number of first struts is selected as appropriate in accordance with the material, the shape, and the like of the second plate, and it is preferably plural.

A shape of the first strut is not particularly limited, and examples thereof include a cylindrical shape, an elliptic cylinder shape, a polygonal prism shape, a truncated cone shape, a truncated pyramid shape, and an amorphous columnar shape.

When a plurality of first struts are provided, an arrangement thereof is not particularly limited. The plurality of first struts are preferably each arranged in such a manner to have regular intervals between adjacent first struts.

The first metal plate preferably has a fine uneven structure at a portion contacting the resin fixing part. This allows the resin fixing part to be partially incorporated into recesses of the fine uneven structure of the first metal plate. As a result, the first metal plate is more strongly bonded with the resin fixing part. Therefore, the air tightness of the temperature control device can be maintained over a longer period.

A state of the fine uneven structure is not particularly limited as long as a sufficient bonding strength between the first metal plate and the resin fixing part (hereinafter, also simply referred to as "bonding strength") is obtained.

In the uneven structure, the recesses have an average pore size of preferably from 5 nm to 500 µm, more preferably from 10 nm to 150 µm, still more preferably from 15 nm to 100 µm.

In the uneven structure, the recesses have an average pore depth of preferably from 5 nm to 500 µm, more preferably from 10 nm to 150 µm, still more preferably from 15 nm to 100 µm.

When at least one of the average pore size or the average pore depth of the recesses in the uneven structure is in the above-described range, a higher bonding strength tends to be obtained.

The average pore size and the average pore depth of the recesses are determined by a method according to JIS B0601-2001.

The fine uneven structure is formed by performing a roughening treatment on a surface of the first metal plate. A method of performing the roughening treatment at the surface of the metal member is not particularly limited, and a variety of known methods may be employed.

From the standpoint of improving the bonding strength, the surface of the first metal plate may be further subjected to a functional group addition treatment. For this functional group addition treatment, a variety of known methods may be employed.

A shape and a size of the temperature control device are not particularly limited, and are selected as appropriate in accordance with the type and the like of the heat exchange object. For example, the temperature control device has a rectangular parallelepiped shape.

Hereinafter, the second plate made of a metal may be referred to as "second metal plate". The second plate made of a resin may be referred to as "second resin plate". The flow path wall part made of a metal may be referred to as "metal flow path wall part". The flow path wall part made of a resin may be referred to as "resin flow path wall part".

A configuration of the temperature control device is not particularly limited, and may be a first configuration, a second configuration, a third configuration, or a fourth configuration, depending on the materials of the second plate and the flow path wall part.

In the first configuration, the temperature control device includes the first metal plate, the second metal plate, the resin flow path wall part, and the resin fixing part.

In the second configuration, the temperature control device includes the first metal plate, the second metal plate, the metal flow path wall part, and the resin fixing part.

In the third configuration, the temperature control device includes the first metal plate, the second resin plate, the resin flow path wall part, and the resin fixing part.

In the fourth configuration, the temperature control device includes the first metal plate, the second resin plate, the metal flow path wall part, and the resin fixing part.

The first to the fourth configurations will now be described in this order.

### (1.1) First Configuration

In the first configuration, the temperature control device includes the first metal plate, the second metal plate, the resin flow path wall part, and the resin fixing part. In the first configuration, the second plate is made of a metal, while the flow path wall part is made of a resin.

### (1.1.1) First Metal Plate

The first metal plate is a plate-like material made of a metal. The first metal plate has an inner main surface and an outer main surface. The inner main surface is located at an opposite side from the outer main surface. The "inner main surface" of the first metal plate refers to a main surface of the side at which the flow path wall part is arranged. The "outer main surface" of the first metal plate refers to a main surface of the side at which the flow path wall part is not arranged.

The first metal plate has at least one first connection region. At least one heat exchange object is thermally connected to the first connection region.

A shape of the first connection region viewed from the outer main surface of the first metal plate toward the inner main surface is not particularly limited, and may be, for example, a polygonal shape, a circular shape, an elliptical shape, a star shape, or an amorphous shape. Examples of the polygonal shape include a triangle, a tetragon, a pentagon, a hexagon, and a heptagon. Examples of the triangle include an equilateral triangle, a right triangle, and an isosceles triangle. Examples of the tetragon include a square, a rectangle, a parallelogram, and a trapezoid.

The number of first connection regions is selected as appropriate in accordance with the number, the size, and the like of the at least one heat exchange object, and may be one or plural. Each of a plurality of first connection regions may be formed corresponding to a single heat exchange object, or may be formed corresponding to a single deemed heat exchange object. The term "deemed heat exchange object" used herein refers to a plurality of heat exchange objects that are regarded as a single heat exchange object.

A size of the first connection region is not particularly limited, and is selected as appropriate in accordance with the size, the type, and the like of the heat exchange object. The first connection region preferably has a minimum size required for thermally connecting at least one heat exchange object with the first metal plate.

The at least one first connection region is preferably formed to conform to the shape of at least one heat exchange object that faces the outer main surface of the first metal plate when the heat exchange object and the first metal plate are thermally connected.

The expression "formed to conform to the shape of at least one heat exchange object" used herein means that the first connection region is formed based at the profile shape of the at least one heat exchange object and the position of the at least one heat exchange object.

The "profile shape of heat exchange object" refers to the shape of the heat exchange object viewed from a direction perpendicular to the outer main surface of the first metal plate when the heat exchange object and the first metal plate are thermally connected.

The "position of heat exchange object" refers to the position of the heat exchange object when the heat exchange object and the first metal plate are thermally connected.

At least one first connection region may protrude in the thickness direction of the first metal plate with respect to a region excluding the at least one first connection region. The region of the outer main surface of the first metal plate excluding the at least one first connection region is covered with the resin fixing part. By this, the main surface of the temperature control device at the side of the first metal plate can be a flat surface. As a result, the temperature control device has a superior ease of handling.

The shape of the first metal plate may be, for example, a flat plate shape. The size of the first metal plate is selected as appropriate in accordance with the heat exchange object.

A metal constituting the first metal plate is not particularly limited, and examples thereof include iron, copper, nickel, gold, silver, platinum, cobalt, zinc, lead, tin, titanium, chromium, aluminum, magnesium, manganese, and alloys of these metals (e.g., stainless steel, brass, and phosphor bronze). Thereamong, from the standpoint of thermal conductivity, the metal constituting the first metal plate is preferably aluminum, an aluminum alloy, copper, or a copper alloy, more preferably copper or a copper alloy. From the standpoint of reducing the weight and ensuring the strength, the metal constituting the first metal plate is preferably aluminum or an aluminum alloy.

The first metal plate is thermally connected with at least one heat exchange object in at least one first connection region. Specifically, the first metal plate and the at least one heat exchange object may directly contact each other, or may be indirectly in contact via a thermally conductive layer.

The thermally conductive layer may be, for example, a thermally conductive sheet or a thermally conductive material (TIM: Thermal Interface Material) layer. The "thermally conductive material layer" refers to a layer formed by applying a thermally conductive material. Examples of the thermally conductive material include a thermally conductive grease, a thermally conductive gel, a thermally conductive adhesive, and a phase change material.

### (1.1.2) Second Metal Plate

The second metal plate is a plate-like material made of a metal. The second metal plate has an inner main surface and an outer main surface. The "inner main surface" of the second metal plate refers to a main surface of the side at which the flow path wall part is arranged. The "outer main surface" of the second metal plate refers to a main surface of the side at which the flow path wall part is not arranged.

The second metal plate has a higher mechanical strength than the second resin plate. Therefore, as compared to a case of using the second resin plate, the use of the second metal plate can improve the resistance of the temperature control device against an internal pressure caused by circulation of a heat exchange medium.

The second metal plate preferably has at least one other connection region (hereinafter, also referred to as "second connection region"). The second connection region refers to a region of the outer main surface of the second metal plate, which region is used for thermally connecting the second metal plate with at least one heat exchange object.

Examples of the shape, the number, and the size of the second connection region are the same as those exemplified above as the shape, the number, and the size of the first connection region.

At least one second connection region is preferably formed to conform to the shape of at least one heat exchange object that faces the outer main surface of the second metal plate when the heat exchange object and the second metal plate are thermally connected.

The at least one second connection region may protrude in the thickness direction of the second metal plate with respect to a region of the outer main surface of the second metal plate excluding the at least one second connection region. The region of the outer main surface of the second metal plate excluding the at least one second connection region is covered with the resin fixing part, so that the main surface of the temperature control device at the side of the second metal plate can be a flat surface. As a result, the temperature control device has a superior ease of handling.

The second metal plate preferably has at least one strut (hereinafter, also referred to as "second strut") that physically contacts the first metal plate at a portion of an inner main surface that contacts the resin fixing part.

The at least one second strut of the second metal plate functions as a support of the first metal plate. Accordingly, even when a pressing force is applied to the first metal plate in the thickness direction of the first metal plate, the first metal plate is unlikely to be deformed. For example, when the resin fixing part is formed by insert molding, the at least one second strut serves as a support of the first metal plate against an injection pressure. Therefore, the first metal plate is unlikely to be deformed. As a result, in the temperature control device, a loss of the pressure of a heat exchange medium circulating in the internal flow path can be further reduced. In other words, in the temperature control device, a heat exchange medium can be more efficiently circulated in the internal flow path.

Examples of the number, the shape, and the arrangement of the second strut are the same as those exemplified above as the number, the shape, and the arrangement of the first strut.

The shape of the second metal plate may be, for example, a flat plate shape. The size of the second metal plate is selected as appropriate in accordance with the heat exchange obj ect.

A metal constituting the second metal plate is not particularly limited, and examples thereof include the same metals as those exemplified above as the metal constituting the first metal plate. Thereamong, from the standpoint of thermal conductivity, the metal constituting the second metal plate is preferably aluminum, an aluminum alloy, copper, or a copper alloy, more preferably copper or a copper alloy. From the standpoint of reducing the weight and ensuring the strength, the metal constituting the second metal plate is preferably aluminum or an aluminum alloy.

The second metal plate preferably has a fine uneven structure at a portion that contacts the resin fixing part. This allows the resin fixing part to be partially incorporated into recesses of the fine uneven structure of the second metal plate. As a result, the second metal plate is more strongly bonded with the resin fixing part. Therefore, the air tightness of the temperature control device can be maintained over a longer period.

A state of the fine uneven structure is not particularly limited as long as a sufficient bonding strength between the second metal plate and the resin fixing part (hereinafter, also simply referred to as "bonding strength") is obtained, and is the same as the one exemplified above for the fine uneven structure of the first metal plate.

It is preferred that the second metal plate is thermally connected with at least one heat exchange object in at least one second connection region. Specifically, the second metal plate and the at least one heat exchange object may directly contact each other, or may be indirectly in contact via a thermally conductive layer. Examples of the thermally conductive layer are the same as those exemplified above as the thermally conductive layer of the first metal plate.

### (1.1.3) Resin Flow Path Wall Part

As compared to a case of using a metal flow path wall part, the use of a resin flow path wall part can not only reduce the weight of the temperature control device but also improve the degree of freedom in the design of the internal flow path.

The resin flow path wall part constitutes a portion of a wall part forming the internal flow path. The resin flow path wall part is, for example, a cylindrical or plate-like material made of a resin.

A shape and a size of the resin flow path wall part are selected as appropriate in accordance with the type of the heat exchange object.

The resin flow path wall part is a molded body of a first resin composition. Examples of the resin flow path wall part include an injection-molded product and a press-molded product.

A resin component of the first resin composition is not particularly limited, and may be selected in accordance with the intended use and the like of the temperature control device. Examples of the resin component of the first resin composition include thermoplastic resins (including elastomers) and thermosetting resins. Examples of the thermoplastic resins (including elastomers) include polyolefin resins, polyvinyl chlorides, polyvinylidene chlorides, polystyrene resins, acrylonitrile-styrene copolymer (AS) resins, acrylonitrile-butadiene-styrene copolymer (ABS) resins, polyester resins, poly(meth)acrylic resins, polyvinyl alcohols, polycarbonate resins, polyamide resins, polyimide resins, polyether resins, polyacetal resins, fluorocarbon resins, polysulfone resins, polyphenylene sulfide resins, and polyketone resins. Examples of the thermosetting resins include phenolic resins, melamine resins, urea resins, polyurethane resins, epoxy resins, and unsaturated polyester resins. These resins may be used singly, or in combination of two or more kinds thereof. From the standpoint of moldability, the resin component of the first resin composition preferably contains a thermoplastic resin.

If necessary, the first resin composition may also contain at least one of a filler or an additive. Examples of the filler include fibers (e.g., glass fibers and cellulose fibers), clay, talc, silica, and minerals. These fillers may be used singly, or in combination of two or more kinds thereof. Examples of the additive include heat stabilizers, antioxidants, pigments, anti-weathering agents, flame retardants, plasticizers, dispersants, lubricants, mold release agents, and antistatic agents. These additives may be used singly, or in combination of two or more kinds thereof.

### (1.1.4) Resin Fixing Part

The resin fixing part fixes the second metal plate to the first metal plate. The resin fixing part is a fixing part made of a resin.

The resin fixing part covers a region of the outer main surface of the first metal plate, excluding the at least one first connection region.

It is preferred that the at least one heat exchange object includes the plurality of heat exchange objects, the second metal plate has at least one second connection region for thermally connecting at least one of the plurality of heat exchange objects at the outer main surface thereto, and the resin fixing part covers a region of the outer main surface of the second metal plate, excluding the at least one second connection region.

By this, the temperature control device can more efficiently control the temperature of the plurality of heat exchange objects using the main surface at the side of the first metal plate and the main surface at the side of the second metal plate. In this case, at the main surface at the side of the second metal plate as well, the temperature control device of the disclosure can, as described above, inhibit the occurrence of a short circuit of an electronic component caused by a physical contact with an electronic device that is not a heat exchange obj ect.

When the temperature control device has a rectangular parallelepiped shape with two main surfaces, the resin fixing part may cover the entirety of the four side surfaces, or only parts of the four side surfaces.

A shape and a size of the resin fixing part are not particularly limited, and are selected as appropriate in accordance with the first metal plate, the second metal plate, the resin flow path wall part, and the like.

The resin fixing part may be formed by insert molding or welding.

In the insert molding of the first configuration, a layered body of the first metal plate, the second metal plate, and the resin flow path wall part is inserted into a mold, and a melt of the resin fixing part is injected to a prescribed part of the outer surface of the layered body to form the resin fixing part.

Examples of the welding include heat welding, vibration welding, laser welding, ultrasonic welding, and hot plate welding.

The resin fixing part is preferably formed by insert molding. By this, in the first configuration, as compared to a case where the resin fixing part is formed by welding, the resin fixing part is more certainly incorporated into the gaps of the uneven parts of the surfaces contacting each of the first metal plate and the second metal plate. Therefore, the resin fixing part is more strongly anchored with the first metal plate and the second metal plate. As a result, the air tightness of the temperature control device can be maintained over a longer period.

The resin fixing part is a molded body of a second resin composition. The second resin composition has electrically insulating properties.

A resin component of the second resin composition is not particularly limited as long as the second resin composition has electrically insulating properties, and examples thereof include the same resins as those exemplified above as the resin component of the first resin composition. The resin component of the second resin composition preferably contains a resin compatible with the resin component of the first resin composition. By this, the resin fixing part and the resin flow path wall part are fused together.

The term "compatible" refers to that, in an atmosphere where the resin components constituting the resin fixing part and the resin flow path wall part are melted, these resin components are mixed with each other without being separated.

The phrase "the resin fixing part and the resin flow path wall part are fused together" indicates that the resin flow path wall part and the resin fixing part are anchored with each other at room temperature (e.g., 23°C) without an adhesive, a screw, or the like.

If necessary, the second resin composition may contain at least one of a filler or an additive. Examples of the filler and the additive include the same ones as those exemplified above as fillers and additives that may be contained in the resin composition.

### (1.1.5) Internal Flow Path

The temperature control device includes an internal flow path for circulating a heat exchange medium. The heat exchange medium exchanges heat with a heat exchange object. The internal flow path is located inside the temperature control device.

A shape of the internal flow path is not particularly limited, and is selected as appropriate in accordance with the heat exchange object and the like.

The heat exchange medium is a cooling medium or a heating medium, and it is selected as appropriate in accordance with the type and the like of the heat exchange object.

The "cooling medium" refers to a medium used for drawing heat from the heat exchange object. The cooling medium is, for example, a cooling liquid or a cooling gas. The cooling liquid is not particularly limited as long as it is a liquid generally used for cooling, and examples thereof include water, oils, glycol-based aqueous solutions, air conditioner refrigerants, non-electroconductive liquids, and phase change liquids. Examples of the cooling gas include air and nitrogen gas. The temperature of the cooling medium is adjusted as appropriate in accordance with the type and the like of the heat exchange object.

The "heating medium" refers to a medium used for providing heat to the heat exchange object. The heating medium is, for example, a heating liquid or a heating gas. The heating liquid is not particularly limited as long as it is a liquid generally used as a heating liquid, and examples thereof include water, oils, glycol-based aqueous solutions, air conditioner refrigerants, non-electroconductive liquids, and phase change liquids. Examples of the heating gas include air and water vapor. The temperature of the heating medium is adjusted as appropriate in accordance with the type and the like of the heat exchange object.

The feature that the temperature control device includes the internal flow path indicates that the temperature control device has a supply port and a collection port. The supply port and the collection port are in communication via the internal flow path.

The supply port is a part connected with an external supply component. The supply port guides the heat exchange medium supplied from the supply component into the internal flow path. The supply component supplies the heat exchange medium to the temperature control device.

The collection port is a part connected with a collection component. The collection port guides the heat exchange medium in the internal flow path to the external collection component. This collection component collects the heat exchange medium from the temperature control device.

The supply port and the collection port (hereinafter, collectively referred to as "supply port and the like") may each have a connection component. One example of the connection component is a mail connector (nipple). When the supply port and the like do not have a connection component, the temperature control device may be processed for connecting each of the supply component and the collection component. One example of a processing method is threading.

When the temperature control device has a rectangular parallelepiped shape with two main surfaces, the supply port and the collection port may each be arranged on any of the two main surfaces and four side surfaces. For example, the supply port and the collection port may be arranged at the same main surface or different main surfaces, or may each be arranged only on a side surface of the temperature control device.

The supply port and the like may be constituted by the flow path wall part, or may be constituted by at least one of the first metal plate or the second metal plate.

### (1.1.6) Partition Member

The temperature control device may further include a partition member. The partition member divides the internal flow path and controls the flow direction of the heat exchange medium circulating in the internal flow path. This enables to design the internal flow path more freely.

In the first configuration, the partition member is arranged between the first metal plate and the second metal plate inside the internal flow path. The partition member is fixed to, for example, at least one of the first metal plate or the second metal plate.

When the partition member is fixed to one of the first metal plate or the second metal plate, the partition member may or may not contact the other of the first metal plate or the second metal plate. When the partition member contacts the other of the first metal plate or the second metal plate and is made of a resin, the partition member may be fixed thereto as well.

The partition member may be made of a resin or a metal. When the partition member is made of a metal, the partition member can also function as a fin to improve the heat exchange efficiency. Examples of the resin constituting the partition member include the same resins as those exemplified above as the resin constituting the resin flow path wall part. Examples of the metal constituting the partition member include the same metals as those exemplified above as the metal constituting the first plate.

A fixing method of fixing the partition member to at least one of the first metal plate or the second metal plate is selected as appropriate in accordance with the material of the partition member, and examples of the fixing method include a fusing method, a method using a known additive, a method using a fastening component (hereinafter, also referred to as "mechanical fastening"), and a welding method. These fixing methods may be employed singly, or in combination of two or more kinds thereof. Examples of the fastening component include a volt, a nut, a screw, a rivet, and a pin. Examples of the welding method include metal welding and brazing. When the partition member is made of a metal, the partition member and at least one of the first metal plate or the second metal plate may be an integrally molded product. When the partition member is made of a resin, the partition member and the flow path wall part may be an integrally molded product.

### (1.1.7) One Example of First Configuration

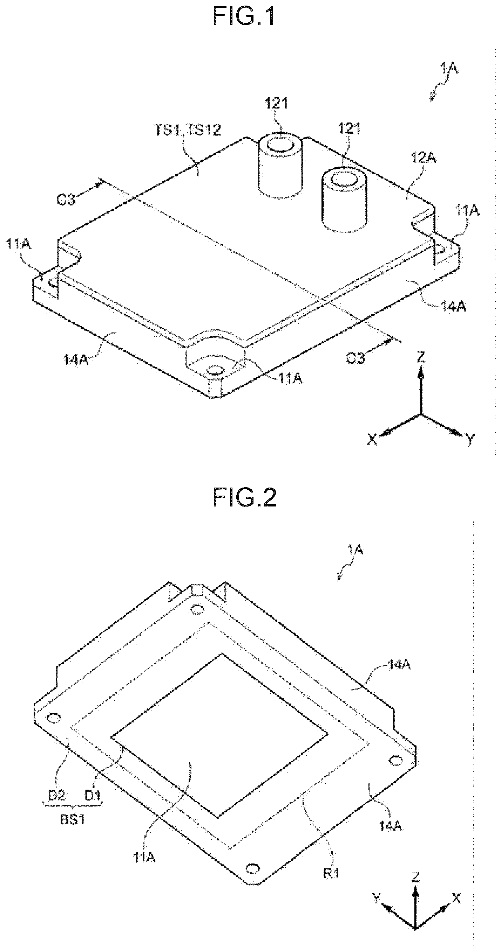

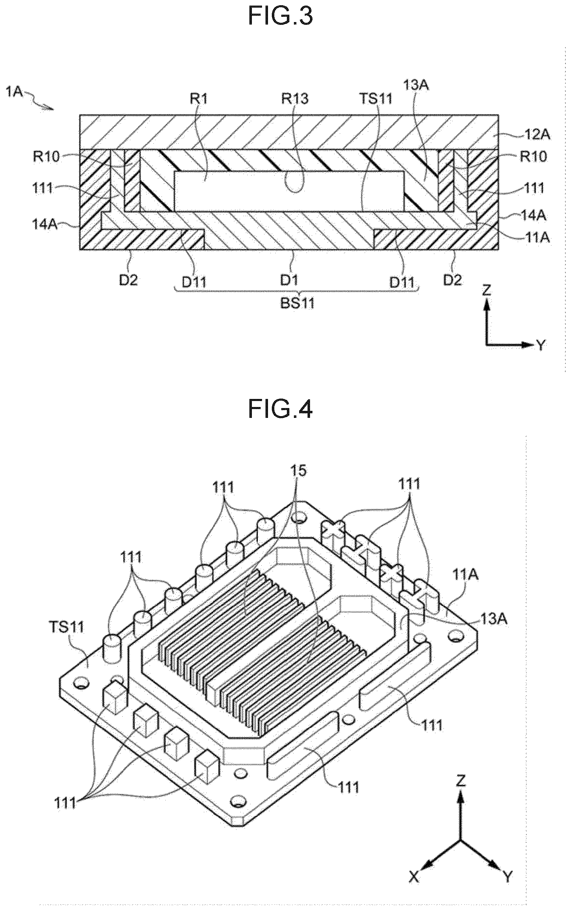

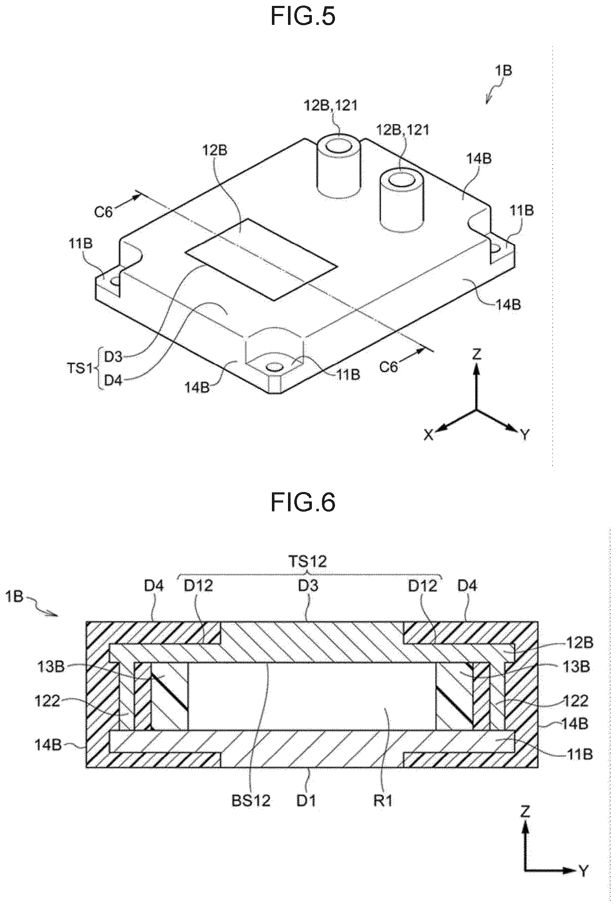

One example of the temperature control device of the first configuration will now be described referring to FIGs. 1 to 7. In FIGs. 3 and 6, a partition member 15 is omitted.

### (1.1.7.1) First Embodiment

As illustrated in FIG. 1, a temperature control device 1A according to a first embodiment includes: a first metal plate 11A; a second metal plate 12A; a resin flow path wall part 13A (see FIG. 3); a resin fixing part 14A; and a partition member 15 (see FIG. 4).

The first metal plate 11A, the resin flow path wall part 13A, and the second metal plate 12A are arranged in this order. The resin fixing part 14A contacts the peripheries of the first metal plate 11A and the second metal plate 12A, fixing the second metal plate 12A to the first metal plate 11A. The partition member 15 is arranged between the first metal plate 11A and the second metal plate 12A.

The second metal plate 12A has a pair of connecting portions 121 (corresponding to a supply port and a collection port).

The side of the temperature control device 1A in which the pair of connecting portions 121 are arranged is defined as "back side" of the temperature control device 1A, and the opposite side thereof is defined as "front side" of the temperature control device 1A. When the temperature control device 1A is viewed from the front side, the right-hand side is defined as "right side" of the temperature control device 1A, and the opposite side thereof is defined as "left side" of the temperature control device 1A. In the direction perpendicular to the front-back direction and the left-right direction of the temperature control device 1A, the side at which the second metal plate 12A is arranged is defined as "upper side" of the temperature control device 1A, and the opposite side thereof is defined as "lower side" of the temperature control device 1A. These orientations do not limit the orientation of the temperature control device of the disclosure during use.

In FIGs. 1 to 7, the front side, the back side, the right side, the left side, the upper side, and the lower side correspond to the X-axis positive direction, the X-axis negative direction, the Y-axis positive direction, the Y-axis negative direction, the Z-axis positive direction, and the Z-axis negative direction, respectively.

The temperature control device 1A has a rectangular parallelepiped shape. As illustrated in FIG. 1, the pair of connecting portions 121 of the second metal plate 12A are arranged at the side of an upper main surface TS1 of the temperature control device 1A. As illustrated in FIG. 2, a lower main surface BS1 of the temperature control device 1A is in the form of a flat surface. The lower main surface BS1 has a single first connection region D1 and an electrically insulating region D2. The electrically insulating region D2 is a region of the lower main surface BS1 that excludes the first connection region D1, and has electrically insulating properties.

Dimensions of the temperature control device 1A are not particularly limited, and may be selected in accordance with the intended use and the like of the temperature control device 1A. For example, the lower main surface BS1 of the temperature control device 1A may have an area in a range of from 50 cm² to 5,000 cm². For example, the thickness of the temperature control device 1A in the vertical direction (Z-axis direction) may be in a range of from 1 mm to 50 mm.

### (1.1.7.1.1) First Metal Plate

The first metal plate 11A has a flat plate shape. When viewed from the upper side (Z-axis positive direction) toward the lower side (Z-axis negative direction), the shape of the first metal plate 11A is a substantially rectangular shape having its long sides in the front-back direction (X-axis direction).

As illustrated in FIG. 4, the first metal plate 11A has a plurality of first struts 111. The plurality of first struts 111 are regularly formed over the entire circumference of an upper main surface TS11 in a peripheral region of the upper main surface TS11 of the first metal plate 11A. As illustrated in FIG. 3, the plurality of first struts 111 each physically contact the second metal plate 12A. Examples of the shape of the plurality of first struts 111 include a cylindrical shape, a quadrangular prism shape, an elliptic cylinder shape, and an amorphous shape.

A lower main surface BS11 of the first metal plate 11A contains a single first connection region D 1, and a region D11 excluding the first connection region D1. The first connection region D1 protrudes downward (in the Z-axis negative direction) with respect to the region D11 excluding the first connection region D1.

Examples of the material of the first metal plate 11A are the same as those metals exemplified above as the material of the first metal plate.

### (1.1.7.1.2) Second Metal Plate

The second metal plate 12A has a flat plate shape. When viewed from the upper side (Z-axis positive direction) toward the lower side (Z-axis negative direction), the shape of the second metal plate 12Ais a substantially rectangular shape having its long sides in the front-back direction (X-axis direction).

As illustrated in FIG. 1, the second metal plate 12A has a pair of connecting portions 121. The pair of connecting portions 121 protrude upward (in the Z-axis positive direction) from an upper main surface TS12 of the second metal plate 12A.

Examples of the material of the second metal plate 12A are the same as those metals exemplified above as the material of the second metal plate. The material of the second metal plate 12A may be the same as or different from the material of the first metal plate 11A.

### (1.1.7.1.3) Resin Flow Path Wall Part

The resin flow path wall part 13A is a plate-like material made of a resin. The resin flow path wall part 13A constitutes a portion of a wall part forming an internal flow path R1.

As illustrated in FIG. 3, the resin flow path wall part 13Ahas a recessed portion R13. The recessed portion R13 is positioned at a central part in the front-back direction (X-axis direction) and the left-right direction (Y-axis direction) at the lower surface side of the resin flow path wall part 13A. The recessed portion R13 is formed to form the internal flow path R1 in which a cooling medium is circulated, between the recessed portion R13 and the first metal plate 12A.

At least the portion of the lower surface of the resin flow path wall part 13A that surrounds the recessed portion R13 physically contacts the upper main surface TS11 of the first metal plate 11A. Therefore, the internal flow path R1 is formed between the recessed portion R13 and the lower main surface BS11 of the first metal plate 11A.

Examples of the material of the resin flow path wall part 13A are the same as those materials exemplified above for the first thermoplastic resin composition.

### (1.1.7.1.4) Resin Fixing Part

The resin fixing part 14A fixes the second metal plate 12A to the first metal plate 11A. In other words, the resin fixing part 14A integrates the first metal plate 11A, the second metal plate 12A, and the resin flow path wall part 13A.

Examples of the material of the resin fixing part 14A are the same as those materials exemplified above for the second thermoplastic resin composition. The resin component of the second resin composition is compatible with the resin component of the first resin composition. In other words, the resin fixing part 14A and the resin flow path wall part 13A are fused together. Therefore, the resin fixing part is more strongly anchored with the resin flow path wall part. As a result, the air tightness of the temperature control device 1A can be maintained over a longer period.

As illustrated in FIG. 3, a void R10 is formed between the first metal plate 11A and the second metal plate 12A. The void R10 represents a space between the first metal plate 11A and the second metal plate 12A, in which the resin flow path wall part 13A do not contact the peripheries of the first metal plate 11A and the second metal plate 12A. The void R10 is formed over the entire circumference of the peripheries of the first metal plate 11A and the second metal plate 12A.

The void R10 is filled with the resin fixing part 14A. In other words, the resin fixing part 14A physically contacts the periphery of the lower main surface BS11 of the first metal plate 11A, the periphery of the upper main surface TS12 of the second metal plate 12A, and the side surface of the resin flow path wall part 13A.

As illustrated in FIG. 3, the resin fixing part 14A covers the entire surface of the region D11 of the lower main surface B S 11 of the first metal plate 11A, excluding the first connection region D1. Accordingly, a region of the lower main surface BS1 of the temperature control device 1A, which region is different from the first connection region D1, is the electrically insulating region D2.

The surface of the first metal plate 11A that contacts the resin fixing part 14A, and the surface of the second metal plate 12A that contacts the resin fixing part 14A have a fine uneven structure.

The resin fixing part 14A is formed by insert molding. The resin fixing part 14A contains a resin that is compatible with the resin contained in the resin flow path wall part 13A.

### (1.1.7.1.5) Internal Flow Path

The temperature control device 1A has the internal flow path R1 inside. The internal flow path R1 is formed by the first metal plate 11A and the resin flow path wall part 13A. A cooling medium (one example of the heat exchange medium) is circulated in the internal flow path R1.

### (1.1.7.1.6) Partition Member

The partition member 15 divides the internal flow path R1.

The partition member 15 has a plurality of partition walls. As illustrated in FIG. 4, the plurality of partition walls are arranged at prescribed intervals along the left-right direction (Y-axis direction). The plurality of partition walls each have an elongated plate shape. The plurality of partition walls control the flow direction of a cooling medium.

The partition member 15 may be fixed to the first metal plate 11A. Examples of a method of fixing the partition member 15 to the first metal plate 11A include the same methods as those exemplified above as fixing methods.

Examples of the material of the partition member 15 are the same as those materials exemplified above as the material of the partition member. The material of the partition member 15 may be the same as or different from the material of the first metal plate 11A or the resin flow path wall part 13A.

### (1.1.7.1.7) Flow of Cooling Medium

The temperature control device 1A is installed and used such that, for example, a heat-generating body (one example of the heat exchange object) thermally contacts the first connection region D1. In this case, an external supply component is connected to one of the connecting portions 121. An external collection component is connected to the other connecting portion 121. The heat of the heat-generating body is conducted through the first metal plate 11A to a cooling medium filled into the internal flow path R1.

The cooling medium is supplied by the supply component from one of the connecting portions 121 to the internal flow path R1. Most of the cooling medium moves in the internal flow path R1 toward the other connecting portion 121. In this process, the cooling medium exchanges heat with at least one of the first metal plate 12A.

Subsequently, the cooling medium is collected to the external collection component via the other connecting portion 121.

In this manner, the cooling medium absorbs heat from the heat-generating body inside the temperature control device 1A, and is discharged to the outside of the temperature control device 1A. By this, the temperature control device 1A facilitates heat dissipation of the heat-generating body. In other words, the temperature control device 1A controls the temperature of the heat-generating body.

### (1.1.7.1.8) Actions and Effects

As described above referring to FIGs. 1 to 4, the temperature control device 1A includes: the first metal plate 11A; the second metal plate 12A; the resin flow path wall part 13A; the resin fixing part 14A; and the partition member 15. The resin fixing part 14A covers the region D11 of the outer main surface BS11 of the first metal plate 11A, excluding the first connection region D1.

In other words, the lower main surface BS1 of the temperature control device 1A is composed of a single first connection region D1 and the electrically insulating region D2. The electrically insulating region D2 is formed by the resin fixing part 14A, and has electrically insulating properties. This makes an electronic device, which is not a heat exchange object, unlikely to be electrically connected with the first metal plate 11A even when the electronic device physically contacts the temperature control device 1A. As a result, the temperature control device 1A can inhibit the occurrence of a short circuit of an electronic component caused by a physical contact with an electronic device that is not a heat exchange object.

As described above referring to FIGs. 1 to 4, the first metal plate 11A has a plurality of first struts 111 at a portion of the inner main surface TS11 that contacts the resin fixing part 14A. The plurality of first struts 111 physically contact the second metal plate 12A.

The plurality of first struts 111 function as a support of the second metal plate 11A. Accordingly, when the resin fixing part 14Ais formed by insert molding, the plurality of first struts 111 serve as a support of the second metal plate 12A against an injection pressure. This makes the second metal plate 11A unlikely to be deformed. As a result, in the temperature control device 1A, a loss of the pressure of a heat exchange medium circulating in the internal flow path R1 can be reduced. In other words, in the temperature control device 1A, a heat exchange medium can be efficiently circulated in the internal flow path.

As described above referring to FIGs. 1 to 4, the first metal plate 11A and the second metal plate 12A each have a fine uneven structure at their parts contacting the resin fixing part 14A. This allows the resin fixing part 14A to be partially incorporated into recesses of the fine uneven structure of each of the first metal plate 11A and the second metal plate 12A. As a result, the first metal plate 11A and the second metal plate 12A are each more strongly bonded with the resin fixing part 14A. Therefore, the air tightness of the temperature control device 1A can be maintained over a longer period.

As described above referring to FIGs. 1 to 4, the resin fixing part 14A is formed by insert molding. This allows the resin fixing part 14A to be more certainly incorporated into the gaps of the uneven parts of the surfaces contacting each of the first metal plate 11A and the second metal plate 12A, as compared to a case where the resin fixing part 14A is formed by welding. Therefore, the resin fixing part 14A is more strongly anchored with the first metal plate 11A and the second metal plate 12A. As a result, the air tightness of the temperature control device 1A can be maintained over a longer period.

### (1.1.7.2) Second Embodiment

A temperature control device 1B according to a second embodiment is the same as the temperature control device 1A according to the first embodiment, except that, mainly, the shapes of the first metal plate, the second metal plate, the resin flow path wall part, and the resin fixing part are different, and the temperature control device 1B is not provided with the partition member.

As illustrated in FIG. 5, the temperature control device 1B includes: a first metal plate 11B; a second metal plate 12B; a resin flow path wall part 13B (see FIG. 6); and a resin fixing part 14B.

The first metal plate 11B is the same as the first metal plate 11A, except that the first metal plate 11B does not have the plurality of first struts 111.

The second metal plate 12B is the same as the first metal plate 12A, except that the second metal plate 12B has a different shape as described below.

As illustrated in FIG. 6, the second metal plate 12B has a plurality of second struts 122. In the same manner as the plurality of first struts 111, the plurality of second struts 122 are regularly formed over the entire circumference of a lower main surface BS12 in a peripheral region of the lower main surface BS12 of the second metal plate 12B. As illustrated in FIG. 6, the plurality of second struts 122 each physically contact the first metal plate 11B. Examples of the shape of the plurality of second struts 122 include a cylindrical shape, a quadrangular prism shape, an elliptic cylinder shape, and an amorphous shape.

The plurality of second struts 122 function as a support of the first metal plate 11B. Accordingly, when the resin fixing part 14B is formed by insert molding, the plurality of second struts 122 serve as a support of the first metal plate 11A against an injection pressure. This makes the first metal plate 11A unlikely to be deformed. As a result, in the temperature control device 1B, a loss of the pressure of a heat exchange medium circulating in the internal flow path R1 can be reduced. In other words, in the temperature control device 1B, a heat exchange medium can be efficiently circulated in the internal flow path.

The upper main surface TS12 of the second metal plate 12B contains a single second connection region D3, and a region D12 excluding the second connection region D3. The second connection region D3 protrudes upward (in the Z-axis positive direction) with respect to the region D12 excluding the second connection region D3.

The resin flow path wall part 13B is the same as the resin flow path wall part 13A, except that the resin flow path wall part 13B has a different shape.

The resin flow path wall part 13B is a cylindrical material made of a resin. The resin flow path wall part 13B constitutes a portion of a wall part forming the internal flow path R1.

The resin fixing part 14B is the same as the resin fixing part 14A, except that the resin fixing part 14B has a different shape.

As illustrated in FIG. 6, the resin fixing part 14B covers the entire surface of the region D 12 of the upper main surface TS12 of the second metal plate 12B, excluding the second connection region D3. Accordingly, a region of the upper main surface TS1 of the temperature control device 1A, which region is different from the second connection region D3, is an electrically insulating region D4.

### (1.2) Second Configuration

In the second configuration, the temperature control device includes the first metal plate, the second metal plate, the metal flow path wall part, and the resin fixing part. In the second configuration, the second plate is made of a metal, and the flow path wall part is made of a metal.

The temperature control device of the second configuration is the same as the temperature control device of the first configuration, except that the metal flow path wall part is used in place of the resin flow path wall part.

The first metal plate, the second metal plate, the resin fixing part, and the internal flow path are the same as those described above for the first configuration.

### (1.2.1) Metal Flow Path Wall Part

The metal flow path wall part has a higher mechanical strength than the resin flow path wall part. Therefore, as compared to a case of using the resin flow path wall part, the use of the metal flow path wall part can improve the resistance of the temperature control device against an internal pressure caused by circulation of a heat exchange medium.

The metal flow path wall part constitutes a portion of a wall part forming the internal flow path. This flow path wall part is, for example, a cylindrical or plate-like material made of a metal.

A shape and a size of the metal flow path wall part are selected as appropriate in accordance with the type of the heat exchange object.

A metal constituting the metal flow path wall part is not particularly limited, and examples thereof include the same metals as those exemplified above as the metal constituting the first metal plate. The metal constituting the metal flow path wall part may be the same as or different from the metal constituting each of the first metal plate and the second metal plate.

The metal flow path wall part may be a body separate from each of the first metal plate and the second metal plate. In this case, a method of fixing the metal flow path wall part to at least one of the first metal plate or the second metal plate is not particularly limited, and examples thereof include insert molding and a method using a known additive.

The metal flow path wall part may also be a product integrally molded with at least one of the first metal plate or the second metal plate. Specifically, the first metal plate and the metal flow path wall part may be a metal integrally molded product. The second metal plate and the metal flow path wall part may also be a metal integrally molded product. The first metal plate and a portion of the metal flow path wall part, as well as the second metal plate and the remainder of the metal flow path wall part, may each be a metal integrally molded product. Examples of these metal integrally molded products include roll-molded products, die-cast molded products, cut products, rolled products, press-molded products, and extruded materials.

When the metal constituting the metal flow path wall part and the metal constituting at least one of the first metal plate or the second metal plate are different kinds of metals, the temperature control device preferably includes an electrically insulating layer. The electrically insulating layer is interposed between the metal flow path wall part and at least one of the first metal plate or the second metal plate. This makes the different kinds of metals unlikely to electrically contact each other. Thus, the occurrence of electric corrosion between the different kinds of metals can be inhibited. As a result, the first metal plate and the second metal plate are unlikely to be corroded.

The electrically insulating layer is not particularly limited as long as it is a film having electrical insulating properties, and examples thereof include an adhesive layer, an inserted bonding layer, and an elastomer packing.

### (1.2.2) Partition Member

The temperature control device of the second configuration may further include a partition member. The partition member divides the internal flow path and controls the flow direction of the heat exchange medium circulating in the internal flow path. This enables to design the internal flow path more freely.

In the second configuration, the partition member is arranged between the first metal plate and the second metal plate inside the internal flow path. The partition member is fixed to, for example, at least one of the first metal plate or the second metal plate.

Examples of the partition member and a fixing method include the same ones as those exemplified above as the partition member and the fixing method of the first configuration.

### (1.2.3) One Example of Second Configuration

One example of the temperature control device of the second configuration will now be described referring to FIGs. 1, 4, and 7 to 9.

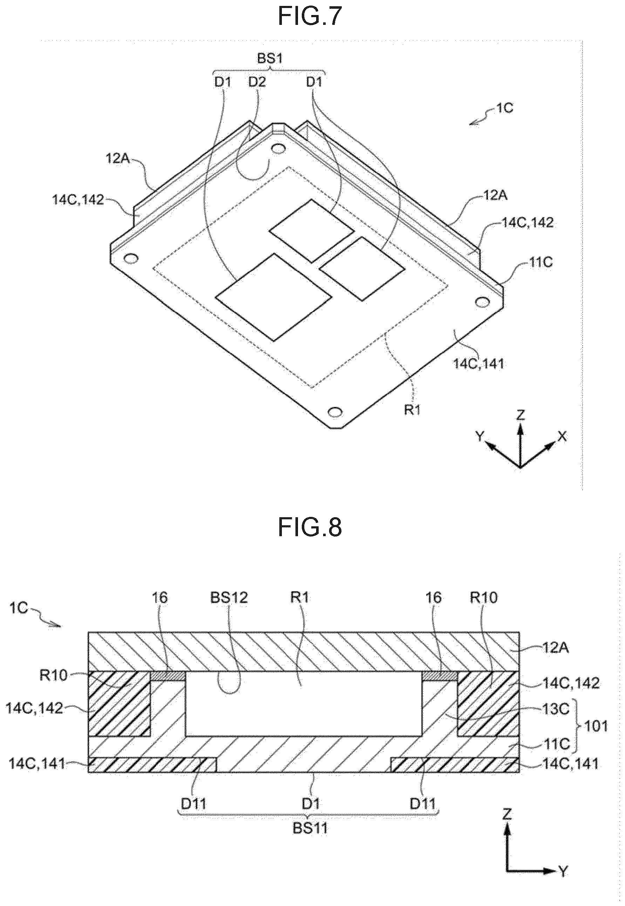

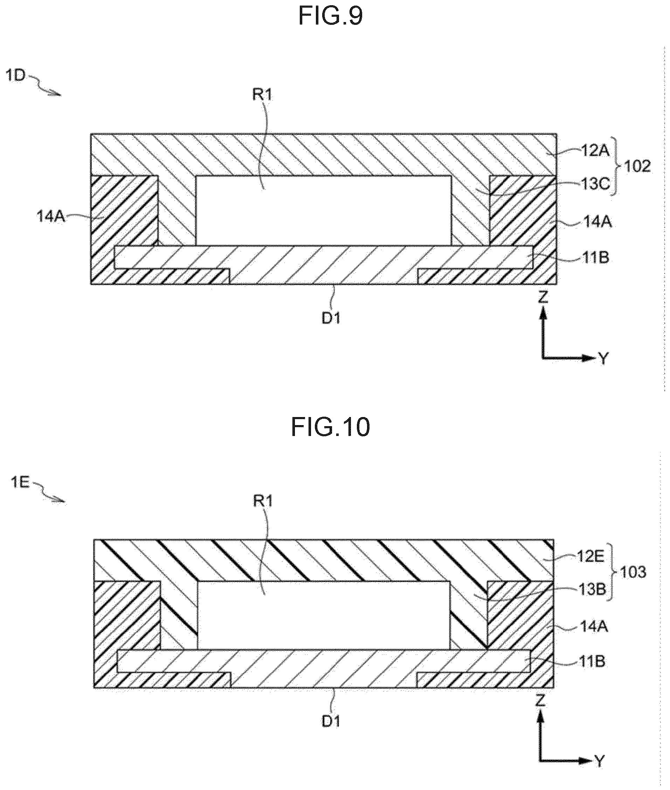

FIG. 8 illustrates a cross-section of a temperature control device 1C according to a third embodiment, which is taken along the same cut line as the cut line C3-C3 illustrated in FIG. 1. FIG. 9 illustrates a cross-section of a temperature control device 1D according to a sixth embodiment, which is taken along the same cut line as the cut line C3-C3 illustrated in FIG. 1. In FIGs. 8 and 9, the partition member 15 is omitted.

### (1.2.3.1) Third Embodiment

The temperature control device 1C according to the third embodiment is the same as the temperature control device 1A according to the first embodiment, except that, mainly, the flow path wall part is made of a metal, the temperature control device 1C has three first connection regions, and the first metal plate has a different shape.

As illustrated in FIG. 8, the temperature control device 1C includes: a first metal plate 11C; the second metal plate 12A; a metal flow path wall part 13C; a resin fixing part 14C; the partition member 15 (see FIG. 4); and an electrically insulating layer 16. The first metal plate 11C and the metal flow path wall part 13C are a metal integrally molded product 101. The metal integrally molded product 101 is, for example, a roll-molded product, a die-cast molded product, a cut product, a rolled material, a press-molded product, or an extruded material.

The first metal plate 11C is the same as the first metal plate 11A, except that the first metal plate 11C has a different shape. As illustrated in FIGs. 7 and 8, the side surface of the first metal plate 11C is exposed at the side surface of the temperature control device 1C. The first metal plate 11C does not have the plurality of first struts 111. A lower main surface BS11 of the first metal plate 11C contains three first connection regions D1 (see FIG. 7), and a region D11 excluding the first connection regions D1.

The metal flow path wall part 13C is the same as the resin flow path wall part 13B, except that the metal flow path wall part 13C is made of a metal.

The metal constituting the metal flow path wall part 13C is the same as the constituting the first metal plate 11C. In the third embodiment, the metal constituting the metal flow path wall part 13C and the metal constituting the second metal plate 12A are different kinds of metals.

The resin fixing part 14C is the same as the resin fixing part 14A, except that the resin fixing part 14C has a different shape.

The resin fixing part 14C includes a first resin fixing part 141 and a second resin fixing part 142. The first resin fixing part 141 covers a region D 11 of the first metal plate 11C, excluding the first connection regions D1. A void R10 is filled with the second resin fixing part 142.

The electrically insulating layer 16 is interposed between the metal flow path wall part 13C and the second metal plate 12A. By this, the occurrence of electric corrosion between the metal flow path wall part 13C and the second metal plate 12A can be inhibited. As a result, the metal flow path wall part 13C and the second metal plate 12A are unlikely to be corroded. Examples of the electrically insulating layer 16 include the same ones as those exemplified above as electrically insulating layers.

### (1.2.3.1) Fourth Embodiment

The temperature control device 1D according to the fourth embodiment is the same as the temperature control device 1A according to the first embodiment, except that, mainly, the flow path wall part is made of a metal, and the second metal plate has a different shape.

As illustrated in FIG. 9, the temperature control device 1D includes: the first metal plate 11B; the second metal plate 12A; the metal flow path wall part 13C; the resin fixing part 14A; and the partition member 15 (see FIG. 4). The second metal plate 12A and the metal flow path wall part 13C are a metal integrally molded product 102. The metal integrally molded product 102 is, for example, a roll-molded product, a die-cast molded product, a cut product, a rolled material, a press-molded product, or an extruded material.

In the fourth embodiment, the metal constituting the metal flow path wall part 13C and the metal constituting the first metal plate 11B are the same. Therefore, in the temperature control device 1D, electric corrosion between the metal flow path wall part 13C and the first metal plate 11C is unlikely to occur, even without the electrically insulating layer 16 being interposed between the metal flow path wall part 13C and the first metal plate 11B as in the temperature control device 1C according to the third embodiment.

### (1.3) Third Configuration

In the third configuration, the temperature control device includes the first metal plate, the second resin plate, the resin flow path wall part, and the resin fixing part. In the third configuration, the second plate is made of a resin, and the flow path wall part is made of a resin.

The temperature control device of the third configuration is the same as the temperature control device of the first configuration, except that the second resin plate is used in place of the second metal plate.

The first metal plate, the resin fixing part, and the internal flow path are the same as those described above for the first configuration.

### (1.3.1) Second Resin Plate

As compared to a case of using the second metal plate, the use of the second resin plate can reduce the weight of the temperature control device.

The second resin plate is a plate-like material made of a resin. The shape of the second resin plate may be, for example, a flat plate shape. The size of the second metal plate is selected as appropriate in accordance with the heat exchange object.

The second resin plate is a molded body of a third resin composition. Examples of the second resin plate include an injection-molded product and a press-molded product.

A resin component of the third resin composition is not particularly limited, and examples thereof include the same resins as those exemplified above as the resin component of the first resin composition.

If necessary, the third resin composition may also contain at least one of a filler or an additive. Examples of the filler and the additive include the same ones as those exemplified above as fillers and additives that may be contained in the resin composition.

### (1.3.2) Resin Flow Path Wall Part

Examples of the resin flow path wall part include the same ones as those exemplified above as the resin flow path wall part of the first configuration.

The resin flow path wall part may be a body separate from the second resin plate. In this case, a method of fixing the resin flow path wall part to the second resin plate is not particularly limited, and examples thereof include welding and a method using a known additive.

The resin flow path wall part and the second resin plate may be a resin integrally molded product. Examples of the resin integrally molded product include an injection-molded product and a press-molded product.

### (1.3.3) Partition Member

The temperature control device of the third configuration may further include a partition member. The partition member divides the internal flow path and controls the flow direction of the heat exchange medium circulating in the internal flow path. This enables to design the internal flow path more freely.

In the third configuration, the partition member is arranged between the first metal plate and the second resin plate inside the internal flow path. The partition member is fixed to, for example, at least one of the first metal plate or the second resin plate.

Examples of the partition member and a fixing method include the same ones as those exemplified above as the partition member and the fixing method of the first configuration.

### (1.3.4) One Example of Third Configuration

One example of the temperature control device of the third configuration will now be described referring to FIGs. 1, 4, and 10.

FIG. 10 illustrates a cross-section of a temperature control device 1E according to a fifth embodiment, which is taken along the same cut line as the cut line C3-C3 illustrated in FIG. 1. In FIG. 10, the partition member 15 is omitted.

### (1.3.4.1) Fifth Embodiment

The temperature control device 1E according to the fifth embodiment is the same as the temperature control device 1A according to the first embodiment, except that, mainly, the second plate is made of a resin, and the shapes of the second plate and the resin flow path wall part are different.

As illustrated in FIG. 8, the temperature control device 1F includes: the first metal plate 11B; the second resin plate 12E; the resin flow path wall part 13B; the resin fixing part 14A; and the partition member 15 (see FIG. 4). The second resin plate 12E and the resin flow path wall part 13B are a resin integrally molded product 103. The resin integrally molded product 103 is, for example, an injection-molded product and a press-molded product.

The second resin plate 12E is the same as the second metal plate 12A, except that the second resin plate 12E is made of a resin. The resin constituting the second resin plate 12E is the same as the resin constituting the resin flow path wall part 13B.

### (1.4) Fourth Configuration

In the fourth configuration, the temperature control device includes the first metal plate, the second resin plate, the metal flow path wall part, and the resin fixing part. In the fourth configuration, the second plate is made of a resin, while the flow path wall part is made of a metal.

The temperature control device of the fourth configuration is the same as the temperature control device of the second configuration, except that the second resin plate is used in place of the second metal plate.

The first metal plate, the metal flow path wall part, the resin fixing part, and the internal flow path are the same as those described above for the second configuration.

The second resin plate is the same as the one described above for the third configuration.

### (1.4.1) One Example of Third Configuration

One example of the temperature control device of the fourth configuration will now be described referring to FIGs. 1, 4, and 11.

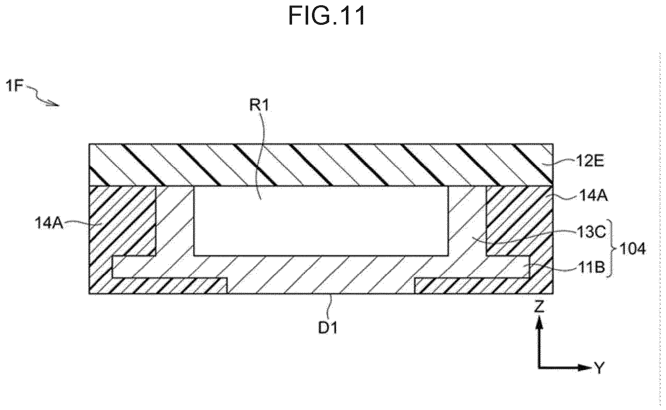

FIG. 11 illustrates a cross-section of a temperature control device 1F according to a sixth embodiment, which is taken along the same cut line as the cut line C3-C3 illustrated in FIG. 1. In FIG. 11, the partition member 15 is omitted.

### (1.4.1.1) Sixth Embodiment

The temperature control device 1F according to the sixth embodiment is the same as the temperature control device 1A according to the first embodiment, except that, mainly, the flow path wall part is made of a metal, the second plate is made of a resin, and the flow path wall part has a different shape.

As illustrated in FIG. 11, the temperature control device 1F includes: the first metal plate 11B; the second resin plate 12E; the metal flow path wall part 13C; the resin fixing part 14A; and the partition member 15 (see FIG. 4). The first metal plate 11B and the metal flow path wall part 13D are a metal integrally molded product 104. The metal integrally molded product 104 is, for example, a roll-molded product, a die-cast molded product, a cut product, a rolled material, a press-molded product, or an extruded material.

### (2) Method of Producing Temperature Control Device

A method of producing a temperature control device according to the disclosure is a method of producing the temperature control device of the disclosure, and includes a step of preparing (hereinafter, also referred to as "preparation step"), a step of forming (hereinafter, also referred to as "formation step"), and a step of performing insert molding (hereinafter, also referred to as "insert molding step"). The preparation step, the formation step, and the insert molding step are carried out in this order. As a result, the temperature control device of the disclosure is obtained.

### (2.1) Preparation Step

The method of producing a temperature control device includes the preparation step. By this, a first metal plate, a second plate, and a flow path wall part are each obtained.

In the preparation step, the first metal plate, the second plate, and the flow path wall part are prepared.

A method of preparing the first metal plate is not particularly limited, and examples thereof include metal forming. Examples of the metal forming include roll molding, die casting, cut processing, rolling, press molding, and extrusion molding.

A method of preparing the second plate is selected as appropriate in accordance with the material and the like of the second plate. A method of preparing a second metal plate is not particularly limited, and examples thereof include metal forming. Examples of a method of preparing a second resin plate is not particularly limited, and examples thereof include resin forming and the like of a third resin composition. Examples of the resin forming include injection molding, cast molding, press molding, insert molding, extrusion molding, and transfer molding.

A method of preparing the flow path wall part is selected as appropriate in accordance with the material and the like of the flow path wall part. A method of preparing a metal flow path wall part is not particularly limited, and examples thereof include metal forming. A method of preparing a resin flow path wall part is not particularly limited, and examples thereof include resin forming and the like of a first resin composition.

When at least one of the first metal plate or the second metal plate and the metal flow path wall part are a metal integrally molded product, a method preparing the metal integrally molded product is not particularly limited, and examples thereof include metal forming.

When the second resin plate and the resin flow path wall part are a resin integrally molded product, a method preparing the resin integrally molded product is not particularly limited, and examples thereof include resin forming.

### (2.2) Roughening Step

The method of producing a temperature control device may include a roughening step. The roughening step is carried out after the preparation step but before the formation step. By this, a fine uneven structure is formed at a portion of at least one of the first metal plate, the second metal plate, or the metal flow path wall part, the portion contacting a resin fixing part. The resin fixing part is thus more strongly anchored to at least one of the first metal plate, the second metal plate, or the metal flow path wall part. As a result, a temperature control device having an excellent air tightness over an extended period is obtained.

In the roughening step, a roughening treatment is performed at a portion of at least one of the first metal plate, the second metal plate, or the metal flow path wall part, the portion contacting the resin fixing part. The roughening treatment is not particularly limited, and may be performed by any known method.

In the roughening step, from the standpoint of improving the bonding strength after the roughening treatment, a functional group addition treatment may be performed as well. The functional group addition treatment may be performed by any known method.

### (2.3) Formation Step

The method of producing a temperature control device includes the formation step. By this, an insert is obtained.

In the formation step, the flow path wall part is sandwiched between the first metal plate and the second plate and forming a gap at which the first metal plate and the second plate face each other (hereinafter, also referred to as "insert gap"). This insert gap is formed by, for example, the periphery of the inner surface of the first metal plate, the periphery of the inner surface of the second plate, and the outer circumferential surface of the flow path wall part. The insert gap is formed, for example, over the entire circumference of the periphery of each of the first metal plate and the second plate.

### (2.4) Insert Molding Step

The method of producing a temperature control device includes the insert molding step. By this, the resin fixing part is formed on the insert.

In the insert molding step, the resin fixing part is insert-molded at a region excluding the gap and excluding the at least one connection region of the outer main surface of the first metal plate.

Specifically, an injection molding machine is employed for the insert molding. The injection molding machine is equipped with an injection molding mold, an injection device, and a clamping device. The injection molding mold includes a movable-side mold and a fixed-side mold. The fixed-side mold is fixed to the injection molding machine. The movable-side mold is movable with respect to the fixed-side mold. The injection device injects a molten second resin composition into a sprue of the injection molding mold at a prescribed injection pressure. The clamping device clamps the movable-side mold at a high pressure such that the movable-side mold is not opened by the filling pressure of the molten second resin composition.

First, the movable-side mold is opened, and the insert is arranged at the fixed-side mold, after which the movable-side mold is closed to clamp the insert. In other words, the insert is housed in the injection molding mold. By this, a molding space for the formation of the resin fixing part is formed between the insert and the injection molding mold.

Subsequently, the injection molding machine fills the molten second resin composition into the molding space at a high pressure.

In this process, it is preferred that the first metal plate has at least one first strut physically contacting the second plate in a portion of the inner main surface at the opposite side from the outer main surface, the portion contacting the resin fixing part. By this, the at least one first strut functions as a support of the second plate. This makes the second plate unlikely to be deformed even when an injection pressure is applied to the second plate in the direction toward the inner main surface of the second plate. As a result, a temperature control device having an excellent air tightness over an extended period is obtained.

Thereafter, the molten second resin composition inside the injection molding mold is cooled and solidified. By this, the resin fixing part is formed on the insert. In other words, the temperature control device of the disclosure is obtained.

The disclosure of Japanese Patent Application No. 2022-010379 filed on January 26, 2022, is hereby incorporated by reference in its entirety.

All the documents, patent applications, and technical standards that are described in the present specification are hereby incorporated by reference to the same extent as if each individual document, patent application, or technical standard is concretely and individually described to be incorporated by reference.

## Claims

1. A temperature control device for controlling a temperature of at least one heat exchange object, the temperature control device comprising:
a first plate made of a metal;
a second plate;
a flow path wall part sandwiched between the first plate and the second plate; and
a resin fixing part fixing the second plate to the first plate, wherein:
an internal flow path for circulating a heat exchange medium is formed by at least one of the first plate or the second plate, and the flow path wall part,
the first plate comprises at least one connection region for thermally connecting the at least one heat exchange object thereto, at an outer main surface of a side at which the flow path wall part is not arranged, and
the resin fixing part covers a region of the outer main surface excluding the at least one connection region.

2. The temperature control device according to claim 1, wherein the first plate comprises at least one strut that physically contacts the second plate at a portion of an inner main surface at an opposite side from the outer main surface, the portion contacting the resin fixing part.

3. The temperature control device according to claim 1 or 2, wherein the first plate has a fine uneven structure at a portion that contacts the resin fixing part.

4. The temperature control device according to any one of claims 1 to 3, wherein:
the second plate is made of a metal, and
at least one of the first plate or the second plate, and the flow path wall part are an integrally molded product made of a metal.

5. The temperature control device according to any one of claims 1 to 4, wherein:
the second plate is made of a metal, and
the flow path wall part is made of a resin.

6. The temperature control device according to claim 4 or 5, wherein:
the at least one heat exchange object comprises a plurality of heat exchange objects,
the second plate comprises at least one other connection region for thermally connecting at least one of the plurality of heat exchange objects thereto, at an outer main surface of a side at which the flow path wall part is not arranged, and
the resin fixing part covers a region of the outer main surface of the second plate excluding the at least one other connection region.

7. The temperature control device according to any one of claims 4 to 6, wherein the second plate has a fine uneven structure at a portion that contacts the resin fixing part.

8. The temperature control device according to any one of claims 1 to 3, wherein the second plate and the flow path wall part are made of a resin.

9. The temperature control device according to any one of claims 1 to 8, wherein the resin fixing part is formed by insert molding.

10. A method of producing a temperature control device, which the temperature control device according to any one of claims 1 to 9, the method comprising:
a step of preparing the first plate, the second plate, and the flow path wall part;
a step of sandwiching the flow path wall part between the first plate and the second plate and forming a gap at which the first plate and the second plate face each other; and
a step of insert-molding the resin fixing part at a region excluding the gap and excluding the at least one connection region of the outer main surface of the first plate.

11. The method of producing a temperature control device according to claim 10, wherein the first plate comprises at least one strut that physically contacts the second plate at a portion of an inner main surface at an opposite side from the outer main surface, the portion contacting the resin fixing part.
